# EUROPEAN PATENT APPLICATION

(11) **EP 1 463 398 A2**
(43) Date of publication of application: **29.09.2004**
(21) Application number: 04100721.2
(22) Date of filing: 24.02.2004
(51) Int. Cl.: H05K 7/20

(54) **Constructions for housing electronic equipment**

(30) Priority: 22.03.2003 GB 3066636
(71) Applicant: MOTOROLA, INC., Schaumburg, IL 60196 (US)
(72) Inventor: RONG, Jorgen, 2600, Glostrup (DK); LARSEN, Anders Stensgaard, 2600, Glostrup (DK)
(74) Representative: McCormack, Derek James

(57) **Abstract**

A construction for the housing of electronic equipment comprising a casing (1a), a plurality of electronic modules (9, 13, 17) in the casing, and a cooling arrangement for providing cooling of the electronic modules, wherein the cooling arrangement is adapted to provide cooling by air convection without the assistance of any fan, wherein a first one or more of the modules (13) is housed in a first enclosure (15) within the construction and a second one or more of the modules (9) is housed in a second enclosure (11) within the construction, the first and second enclosures being separated (7) to inhibit mixing of the air which cools the modules respectively in the first and second enclosures, wherein the modules extend vertically with vertically extending airflow gaps adjacent to the modules.

## Description

### Field of the Invention

This invention relates to constructions for housing electronic equipment. In particular, it relates to constructions which provide cooling of electronic equipment housed thereby.

### Background of the Invention

Some electronic and electrical equipment generates considerable waste heat in use and an arrangement is needed to remove the heat to leave the equipment at a safe operating temperature. A base transceiver station as used in a mobile communications network is such equipment.

A base transceiver station typically comprises a cabinet in which is housed electrical and electronic equipment in the form of various interconnected modules which carry out the various functions of the station. The equipment usually consists of modules that have different power dissipation rates and different sensitivities to ambient temperature. In general, the modules may be considered to consist of high power modules and low power modules depending on their power dissipation rate. Usually, the high power modules will be designed to operate at the ambient temperature that results from the heating of the air around them by their power dissipation. If the low power modules are also tolerant to a similar ambient temperature the high power and low power modules may be housed together in the same cabinet. However if any of the low power modules have a high sensitivity to ambient temperature this simple arrangement is not possible. The traditional way of dealing with this problem is to apply fans to cool the high power modules and arrange the airflow from the high power modules so the hot air is led out of the cabinet. However the fans have a finite lifetime and it is necessary to monitor the conditions inside the cabinet to check that the fans are working properly. Also, when the fans have an operating fault, it is necessary to close down the base station so that the fan(s) may be serviced or replaced.

The purpose of the present invention is to provide a construction for the housing of electronic equipment, especially a base transceiver station for use in a mobile telecommunications network, in which the problems associated with prior art constructions as described earlier are reduced.

### Summary of the invention

According to the present invention a construction for the housing of electronic equipment comprises a casing, a plurality of electronic modules in the casing, and a cooling arrangement for providing cooling of the electronic modules, wherein the cooling arrangement provides cooling by air convection without the assistance of any fan, wherein a first one or more of the modules are housed in a first enclosure within the construction and a second one or more of the modules having an average power dissipation rate different from that of the first one or more modules are housed in a second enclosure within the construction, the first and second enclosures being separated to inhibit mixing of the air which cools the modules respectively in the first and second enclosures.

The cooling arrangement may be such as to allow a single flow of coolant air to enter the construction in a base region thereof and to split the flow into a first flow which passes through the first enclosure and a second flow which passes through the second enclosure. In this form the base region may be an open region in which connections such as cables run between modules in the first and second enclosures. Alternatively, separate air intakes may be provided for delivery of coolant air to each of the first and second enclosures.

An air inlet grill may be provided to allow air to enter a base region of the construction. Similarly, a an air outlet grill may be provided to allow heated air to leave a top region of the construction. One or both of these grills may be provided in a side wall of the casing.

An inlet air channel having a sloping wall may be provided to direct air toward the first enclosure for cooling the at least one module therein and an output air channel having a sloping wall may be provided to direct outside the casing heated air from one of the enclosures having at least one of the modules therein.

The construction may include one or more conducting heat sinks adapted to remove heat from a region adjacent to one or more of the modules by conduction.

The electronic equipment may comprise at least part of a base transceiver station of a mobile communications system. For example, the station may be one built to operate in accordance with TETRA industry standards, as defined by the ETSI (European Telecommunications Standards Institute).

The invention allows separate air cooling of modules in the first and second enclosures, especially of a base transceiver station, without the undesirable use of fans and without sensitive low power modules being overheated by the hot air heated by higher power modules. For example, the enclosure in which the low power modules are housed may be kept at a temperature which is about 10 Celsius degrees below that which it would reach if the airflow from high power modules were allowed to mix with the airflow near the low power modules.

Embodiments of the present invention will now be described by way of example only, with reference to the accompanying drawings, in which:

### Brief Description of the accompanying drawings

FIG. 1 is a cross-sectional front view of a construction of a base transceiver station embodying the invention.

FIG. 2 is a cross-sectional front view of an alternative construction of a base transceiver station embodying the invention.

### Description of embodiments of the invention

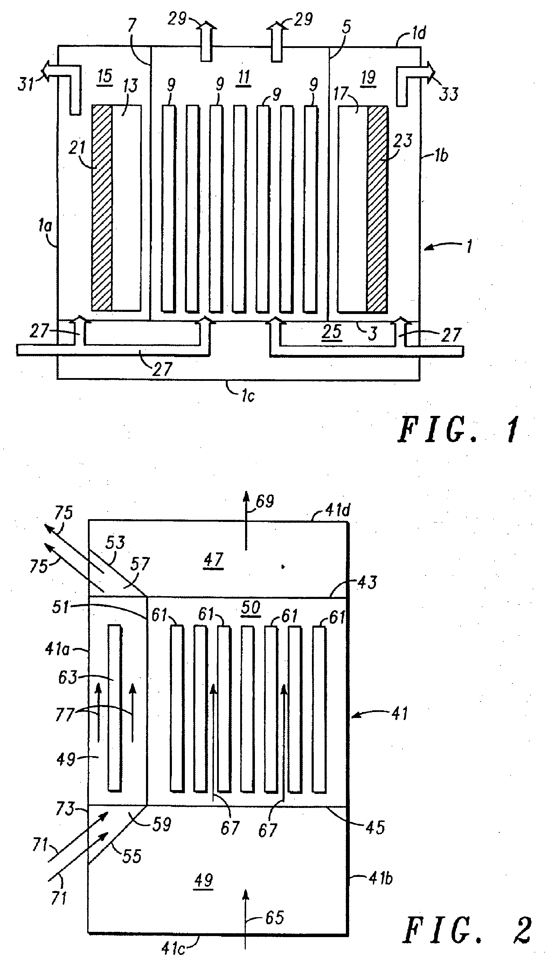

A construction of a base transceiver station for use in a mobile communications system, e.g. a TETRA system, is shown in FIG.1. The construction includes an outer casing 1 made of sheet metal, e.g. steel, and an inner partitioning base 3 and walls 5, 7 made of the same material. Seven electronic processing modules 9 for generation and processing of electronic control signals and communications signals to be transmitted by and received by the base station are enclosed in an enclosure 11 formed between the walls 5, 7, the base 3 and a top 1d of the casing 1. The modules 9 each have a power dissipation of about 15W and so are considered to be low power modules. Two electronic modules 13 (one shown in FIG. 1) are housed in an enclosure 15 formed between the wall 7,a side wall 1a of the outer casing 1, the top 1d and the base 3. Similarly, two electronic modules 17 (one shown) are housed in an enclosure 19 formed between the wall 5,the top 1d, the outer casing 1 and the base 3. The modules 13 and 17 dissipate about 50W and are therefore considered to be high power modules. These modules may for example be power supply, power amplifier and power combiner modules. A heat sink 21 is provided in the enclosure 15 adjacent to the modules 13 on their outside face, i.e. their face which faces away from the wall 7. Simlarly, a heat sink 23 is provided adjacent to the modules 17 in the enclosure 19 on their outer face, i.e. which faces away from the wall 5. The heat sinks 21 and 23 may be made in a known way, e.g. from blocks of metal such as aluminium. The heat sinks 15, 19 conduct heat laterally from the modules 13 and 17.

A base enclosure 25 is formed between the sides 1a and 1b and a base 1c of the casing 1 and the base 3. Cool air from the region outside the casing 1 may be drawn into the enclosure 25 via openings (not shown) in the sides 1a and 1b near the base 1c. The base 3 also includes air passages (not shown) through which the air may pass to flow into the enclosures 11, 15 and 19 as indicated by arrows 27. The air passes upward in the enclosure 11 and takes away heat from the modules 9 by convection. Temperate air heated by the modules 9 leaves from the enclosure 11 via openings (not shown) in the top 1d of the casing 1 as indicated by arrows 29.

The air from the enclosure 25 also passes into the enclosures 15 and 19 via openings in the base 3 at its sides. This air rises and takes away heat from the modules 13 and 17 by convection in addition to the loss of heat by conduction via the heat sinks 21 and 23. Hot air from the enclosure 15 and hot air from the enclosure 19 leaves via openings (not shown) in the sides 1a, 1b near the top 1c of the casing 1 as indicated by arrows 31, 33. Thus, the outflow of hot air from the enclosures 15 and 19 in which the modules 13 and 17 are housed is separate from the outflow of temperate air from the enclosure 11 in which the modules 9 are housed thereby protecting the modules 9 from the hot air in the enclosures 15, 19.

An alternative embodiment of the invention is shown in FIG. 2. In this case, a base transceiver station is housed in a casing 41 having sides 41a and 41b, a base 41c and a top 41d. An upper partition 43 is provided inside the casing 41 beneath the casing top 41d and extends between the sides 41a and 41b thereby forming an enclosure 47. A lower partition 45 is provided inside the casing 41 above the base 1c and extends between the sides 41a and 41b thereby forming a lower enclosure 49. An enclosure 50 is formed between the partitions 43 and 45, the side 41b and a vertical partition wall 51 extending between the partitions 43 and 45. A vertically extending enclosure 49 is defined between the partitions 43 and 45, the side 1a and the partition wall 47. A sloping partition wall 53 is formed in the enclosure 47 and extends between the partition 43 where the partition wall 51 joins it. A sloping partition wall 53 is formed in the enclosure 47 and extends between the partition 43 where the partition wall 51 joins it. A wedge shaped upper enclosure 57 is formed between the sloping partition 53, the partition 43 and the side 41a. A wedge shaped lower enclosure 59 is formed between the sloping partition 55, the partition 45 and the side 41a.

Electronic modules 61 are housed in the enclosure 50 and electronic modules 63 are housed in the enclosure 49.

Cool air from the region outside the casing 41 may be drawn into the enclosure 49 via openings (not shown) in the base 41c. The partitions 43 and 45 also includes air passages (not shown) through which the air may pass to flow from the enclosure 49 to the enclosure 50 then to the enclosure 47 as indicated by arrows 65, 67 and 69. The air passes upward in the enclosure 50 and takes away heat from the modules 61 by convection. The air leaves the enclosure 47 via openings (not shown) in the top 41d.

Cool air is also drawn separately into the enclosure 59, as indicated by arrows 71 via a grill 73 formed in the side 41a of the casing 41. The air enters the enclosure 49 as indicated by arrows 77 via openings (not shown) in the partition 45 and takes heat away from the modules 63 by convection. The heated air passes into the enclosure 57 and is thereby directed out of the casing 1 as indicated by arrows 75 via a grill 79 in the side 41a of the casing 41.
In this manner, the flow of air employed to cool the modules 63 is separate from the flow of air employed to cool the modules 61. The arrangement comprising the enclosures 59, 49 and 57 thus forms a separate chimney construction.

## Claims

1. A construction for the housing of electronic equipment comprising a casing (1a), a plurality of electronic modules (9, 13, 17) in the casing, and a cooling arrangement for providing cooling of the electronic modules, wherein the cooling arrangement is adapted to provide cooling by air convection without the assistance of any fan, wherein a first one or more of the modules (13) is housed in a first enclosure (15) within the construction and a second one or more of the modules (9) is housed in a second enclosure (11) within the construction, the first and second enclosures being separated (7) to inhibit mixing of the air which cools the modules respectively in the first and second enclosures, wherein the modules extend vertically with vertically extending airflow gaps adjacent to the modules.

2. A construction according to claim 1 wherein the cooling arrangement is such as to allow a single flow of coolant air to enter the construction in a base region thereof and to split the flow into a first flow which passes through the first enclosure and a second flow which passes through the second enclosure.

3. A construction according to claim 2 wherein the base region is an open region in which connection run between modules in the first and second enclosures.

4. A construction according to claim 2 wherein separate air intakes are provided in a base region for delivery of coolant air to the first and second enclosures.

5. A construction according to any one of the preceding claims wherein the casing includes an air inlet grill to allow coolant air to enter a base region of the construction.

6. A construction according to claim 5 wherein the inlet grill is included in a side wall of the casing.

7. A construction according to any one of the preceding claims wherein the casing includes an air outlet grill to allow heated air to leave a top region of the construction.

8. A construction according to claim 7 wherein the outlet grill is included in a side wall of the casing.

9. A construction according to any one of the preceding claims including an inlet air channel having a sloping wall adapted to direct air toward the first enclosure for cooling of the at least one module therein.

10. A construction according to any one of the preceding claims including an outlet air channel having a sloping wall adapted to direct air away from the first enclosure for removing heat produced by the at least one module therein.

11. A construction according to any one of the preceding claims and including one or more conducting heat sinks adapted to remove heat from a region adjacent to one or more of the modules by conduction.

12. A construction according to any one of the preceding claims wherein the electronic equipment comprises at least part of a base transceiver station for use in a mobile communications system.

13. A construction according to claim 12 wherein the station is built to operate in accordance with TETRA industry standards.
